# EUROPEAN PATENT SPECIFICATION

(11) **EP 4 445 187 B1**
(45) Date of publication and mention of the grant of the patent: **28.10.2026**
(21) Application number: 22830855.7
(22) Date of filing: 07.12.2022
(51) Int. Cl.: G01B 11/27

(54) **APERTURE**
BLENDE
OUVERTURE

(30) Priority: 10.12.2021 EP 21213814
(43) Date of publication of application: 16.10.2024
(73) Proprietor: ASML Netherlands B.V., 5500 AH Veldhoven (NL)
(72) Inventor: TIMMERMANS, Roger Anton Marie, 5500 AH Veldhoven (NL); LINKOW, Alexander Evgenevich, 5500 AH Veldhoven (NL); VAN DORP, Bas Willem Johannes Johanna Anna, 5500 AH Veldhoven (NL); KHOURI, Thomas William Georg, 5500 AH Veldhoven (NL); BROM, Paul Peter Anna Antonius, 5500 AH Veldhoven (NL)
(74) Representative: ASML Netherlands B.V.
(86) International application number: PCT/EP2022/084817
(87) International publication number: WO 2023/104895

(56) References cited:
- US-A- 5 073 831
- US-A1- 2011 249 256
- US-A1- 2012 127 715
- US-A1- 2017 123 177
- US-A1- 2017 367 167
- US-A1- 2018 156 947

## Description

### FIELD

The present invention relates to apertures for detecting a laser beam misalignment. The present invention also relates to a method for detecting misalignment of a laser beam as well as a radiation source comprising such apertures, a lithographic apparatus including such apertures or radiation source, and the use of such apertures, radiation source, lithographic apparatus, or method in a lithographic apparatus or method. The present invention has particular, but not exclusive, application to EUV radiation sources, metrology tools, and EUV lithographic apparatuses and methods.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

EUV lithographic apparatuses generate EUV radiation by depositing energy via a laser beam into a fuel, such as tin. The tin is converted into a plasma and radiation, including EUV radiation, is emitted from the plasma 7 during de-excitation and recombination of electrons with ions of the plasma. The EUV radiation may then be collected for use in imaging. The laser beam is used to convert the tin into a plasma. The EUV source of the EUV lithography apparatus may be divided in different areas or sections. Between said sections and inside said sections, the laser may travel through apertures. The apertures may define the limits between different sections. If the laser beam is misaligned, this can cause damage to the aperture, the function of which is to protect other components of the lithographic apparatus. In turn this can cause contamination of the lithographic apparatus.

Other applications may also suffer this problem. For example, a metrology apparatus generates metrology radiation by depositing energy via a laser beam into a target. The metrology radiation is transmitted to a patterned substrate to check if the pattern within the substrate fulfils the specifications. The substrate may be reticle or a wafer. The laser beam used to convert the target into a plasma is provided via an aperture. If the laser beam is misaligned, this can cause damage to the aperture. In turn this can cause contamination of the substrate or other elements of the apparatus.

It is therefore desirable to provide a means of detecting misalignment of the laser beam and thereby limiting or preventing damage to the apparatus. It is also desirable to reduce or eliminate the risk of contaminants being generated and contaminating the apparatus. The present invention is intended to address these issues.

US2011/249256 describes a laser beam analysis apparatus which includes a focus lens and a cover glass. An attenuation module includes a pair of high reflecting mirror plates disposed in parallel, spaced apart relation to one another at a common angle of incidence to the laser beam. A beam dump is positioned out of a path of travel of the laser beam and in receiving relation to light reflected by the first and second mirrors. A camera detects pots of light that pass through the first and second mirrors. A high power attenuator formed by a highly reflective mirror pair is positioned between the source and the attenuation module.

US2017/367167 describes a beam trap including: a reflector for reflecting a beam, in particular a laser beam, that is incident on a surface of the reflector, and an absorber device for absorbing the beam reflected at the surface of the reflector. The surface of the reflector is segmented and has a plurality of reflector regions that are configured for reflecting a respective partial beam of the incident beam into an absorber region of the absorber device that is associated with the respective reflector region. Also described is a beam guide device having a beam trap, an EUV radiation generation apparatus having a beam guide device, and an associated method for absorbing a beam, in particular for absorbing a laser beam.

US2017/123177 describes a boresight module includes a housing including an input window and an exit window. The boresight module further includes a lateral transfer hollow, dichroic beam splitter, retro-reflector (LTHSR) assembly supported by the housing. The LTHSR assembly includes a dichroic beam splitter. The boresight module further includes a corner cube coupled to the housing and a collimator including a collimator housing coupled to the housing and a target supported by the collimator housing. The target is configured to receive electromagnetic radiation from the input window to emit electromagnetic radiation through the exit window. A method of aligning a device with a boresight alignment module is also described.

### SUMMARY

According to a first aspect of the present invention, there is provided an aperture for detecting misalignment of a laser beam configured to generate plasma when it hits a target, the aperture comprising: a body including a first opening and defining a first axis; a beam dump; an optical element including a second opening wherein the first opening and the second opening are coaxial with the first axis, the optical element being configured to split a misaligned laser beam, which interacts with the optical element, into at least two sub-beams and to allow a nominal laser beam to pass along the first axis through the first and second openings; a laser beam detection system configured to detect laser light, wherein the optical element is configured to direct a first sub-beam to the beam dump, and to direct a second sub-beam to the laser beam detection system. The body may be annular.

The aperture may be for detecting a laser beam misalignment in an EUV source. EUV sources use high-power CO₂ laser beams to provide energy to fuel, usually in the form of tin droplets, to create a plasma, which ultimately releases radiation including EUV radiation. The laser beam passes through an aperture which is designed to prevent the laser beam from breaking out of the system and to also shield sensitive optical components. It will be appreciated that where the laser beam is correctly aligned, it passes through the aperture without hitting the body. In other words, an aligned laser beam simply passes through the aperture. A nominal laser beam will pass along the first axis through the first and second openings. If the laser beam is misaligned, the laser light falls on the aperture causing the material of the aperture to heat up and trigger a temperature switch associated with the aperture. This safety switch triggers shutdown of the laser beam. However, when using 10 micron laser light, the dimension of the aperture is large and it also require active water cooling, which itself takes up more space and requires water infrastructure to provide it with the necessary supply of water for cooling. In addition, few materials are optically transparent at this wavelength. Whilst diamond is transparent at this wavelength, it would be extremely expensive and difficult to manufacture an aperture with diamond components. Furthermore, it can take some seconds for the aperture to react, and this can be slower than the time it takes for the aperture to begin melting, particularly in the case of high intensity beams. This can result in the generation of particles and debris, which can contaminate sensitive optics in the vicinity of the aperture. The aperture may be for detecting laser beam misalignment in a metrology tool or apparatus, which can suffer from similar problems as an EUV source.

For some applications, it may be desired to decrease the wavelength of the laser beam from around 10 microns to around 1 micron. The wavelength may be from 0.5 to 1.5 microns. This increases the intensity and/or power of the laser beam and so any damage caused by misalignment may happen more quickly. It is therefore desirable to provide a means of detecting misalignment of the laser beam whilst avoiding damage to the aperture and/or the generation of particles and debris. Whilst the beam diameter could be increased to reduce intensity, this would require larger optics and beam envelopes throughout the system, which is undesirable.

Metrology tools may also use laser beams with a wavelength around 1 micron. It is therefore desirable to provide a means of detecting misalignment of the laser beam whilst avoiding damage to the aperture and/or the generation of particles and debris.

The present invention addresses this issue by providing an optical element which is configured to split a misaligned laser beam into two sub-beams. Since the laser beam has been split, the intensity or power of the laser light reaching the laser beam detection system is reduced. In this way, the time taken before damage is caused by the misaligned laser is extended and the reduction in intensity may be sufficient to prevent damage. By allowing more time before damage occurs, the safety mechanism has more time to act to prevent the damage from occurring. The splitting of the misaligned laser beam does not need to be equal, and the optical element may be configured such that the majority of the energy of the misaligned laser beam is directed to the beam dump and only a minority of the energy is directed to the laser beam detection system. The optical element may additionally or alternatively be configured to redirect a misaligned laser beam to a detector.

The optical element may include a partially reflective surface configured to reflect a portion of incident laser beam and to transmit another portion of the incident laser beam. In this way, the optical element is able to split the misaligned laser beam into two or more sub-beams. Depending on the configuration of the aperture, the transmitted laser beam may be provided to the beam dump and the reflected laser beam may be provided to the laser beam detection system. In other configurations, the transmitted laser beam may be provided to the laser beam detection system and the reflected laser beam may be directed to the beam dump. The relative proportion of reflected and transmitted laser light may be selected as required. This can be achieved by any suitable means, such as for example, changing the thickness and/or composition of the partially reflective surface. The partially reflective surface may be configured to enlarge the beam and optionally is curved.

The optical element may be configured to enlarge the first sub-beam. By enlarging the first sub-beam, the intensity of the beam when it reaches the beam dump is reduced and so the likelihood of damage to the beam dump is reduced.

The optical element may include a curved surface configured to enlarge the first sub-beam. When the laser beam falls onto the curved surface, the shape of the curved surface causes the laser light to diverge, and this leads to a reduction of intensity upon the beam dump.

The laser beam detection system may be configured to detect a misalignment of the laser beam and send a signal when misalignment is detected. In the nominal case where the laser beam is correctly aligned, it should not fall upon the aperture (aside from some unavoidable stray light), but when it does, the aperture is configured as described herein and the misalignment is detected, and a signal is generated. The signal may be a signal to a controller to shut off the laser beam, or the laser beam source, or to realign the laser beam.

The laser beam detection system may include one or more photodetectors, which may be photodiodes. The photodiodes are able to detect incident laser light and generate a signal, which can be converted into a signal. The photodiodes may be located at any suitable location where they may detect misaligned laser light. In an embodiment, the photodiodes are arranged around a periphery of the first opening in the body of the aperture, which may be an annular body. The photodiodes could be damaged if they were exposed to the original laser beam, but the optical element is configured to reduce the intensity or power of laser light reaching the photodiodes to a level which is tolerated by the photodiodes. Alternatively, or additionally, the laser beam detection system may include a plurality of optical fibres configured to directed laser light to one or more photodetectors.

The optical element may be configured to at least partially diffuse the second sub-beam. In order to avoid potential blind spots where the laser beam detection system is unable to detect laser light, having the optical element at least partially diffuse the laser light means that there is a smaller chance of the laser light not being detected by the laser beam detection system.

The aperture may include a diffuser to at least partially diffuse the second sub-beam. The diffuser may be a separate component to the optical element.

The optical element may be configured to be transmissive to laser light of around 1 micron in wavelength. Since the optical element is required to transmit and/or reflect incident laser light, the laser light needs to be able to transmit through the optical element.

The body may include a plurality of ridges located at an inner surface therefore and configured to absorb any reflected laser light. The ridges may be in any suitable form to limit the further reflection of laser light. The ridges may be in the form of annular rings. The ridges may be optically black or substantially optically black. As such, the ridges may have a surface treatment which ensures low reflectivity and high absorption.

The optical element may be configured to internally reflect at least a portion of the misaligned laser beam. The misaligned laser beam may be split by angling a surface of the optical element to reflect a portion of the misaligned laser light to form a sub-beam. The sub-beam may then be internally reflected in order to direct it to the location of the laser beam detection system.

The aperture may include an enclosure which is optically transparent to light of a predetermined wavelength. The predetermined wavelength is the wavelength of the light comprising the laser beam. The enclosure may be configured to seal at least a portion of the aperture. By enclosing at least, a portion of the aperture, even if particles or debris is generated, it is retained within the enclosure such that it cannot contaminate elsewhere.

The enclosure may enclose at least one of the optical elements, beam dump, and laser beam detection system. In some embodiments, the enclosure may form at least a part of the optical element. As such, the enclosure may be the optical element.

The optical element may be configured to enclose the beam dump and the laser beam detection system.

A seal may be provided between the body and the optical element. The optical element may be configured to direct laser light away from the seal.

The enclosure may comprise fused silica or quartz. Both fused silica and quartz are optically transparent at the wavelength used in an EUV source, around 1 micron, and can be readily formed into the required shape.

The enclosure may be annular and include a central aperture. Since a nominally aligned laser beam passes through the first opening of the aperture, it is desirable to keep this area free of materials which could otherwise interfere with the laser beam. It is only desirable for a material to interact with the laser beam when it becomes misaligned. By having a central aperture, a nominally aligned laser beam can pass through without interacting with the enclosure.

The aperture may further include a translucent optical element configured to diverge the misaligned laser beam.

By including a translucent optical element, an incoming laser beam undergoes multiple reflections and refractions that change the laser beam from a highly parallel configuration to a slightly divergent beam. The translucent optical element may have a surface finish which is rough to cause such multiple reflections and refractions. Since a misaligned laser beam passing through the translucent optical element is diverged, when it hits the aperture, its fluence has been reduced since the laser beam has been spread over a larger area and so the intensity is lessened but the amount of energy being delivered is diminished only slightly, so the aperture heats up at almost the same rate, but there is no damage to the aperture since the energy is delivered over a larger area.

The translucent optical element may the optical element including a second opening wherein the first opening and the second opening are coaxial with the first axis. Alternatively, or additionally, the translucent optical element may be a separate optical element to the optical element including a second opening wherein the first opening and the second opening are coaxial with the first axis. It will be appreciated that the translucent element will include a void or a transparent portion where a nominally aligned laser beam passes through as it is undesirable to cause divergence of an aligned laser beam.

According to an example not falling under the scope of protection, there is provided an aperture for detecting misalignment of a laser beam configured to generate plasma when it hits a target, the aperture comprising: a body including a first opening and defining a first axis; a beam dump; an optical element including a second opening wherein the first opening and the second opening are coaxial with the first axis, wherein the optical element is translucent and is configured to diverge the misaligned laser beam.

The presence of a translucent optical element in the path of a misaligned laser beam causes the misaligned laser beam to diverge. Since the misaligned laser beam has diverged, when it hits the aperture, the energy provided by the misaligned laser beam is deposited over a larger surface area than would have otherwise been the case, resulting in a lower intensity and less likelihood of damage being caused. Although the misaligned laser beam has been diverged, the power is only slightly, if at all reduced, so almost the same amount of energy is delivered and so the misalignment can still be detected just as rapidly, but without the risk of damage.

The optical element may be configured to diverge the misaligned laser beam by at least 5° (half cone angle).

The optical element may include more than one translucent optical element configured to diverge the misaligned laser beam. By providing one or more translucent optical elements in the path of a misaligned laser beam, the misaligned laser beam can be diverged, thereby reducing the intensity of the misaligned laser beam upon hitting the aperture.

Also described is an aperture for detecting a laser beam misalignment within an EUV source, the aperture comprising: a body including a first opening and defining a first axis; a beam dump; a laser beam detection system configured to detect laser light, wherein the aperture further includes an enclosure configured to enclose at least one of the body, beam dump, and laser beam detection system, and the enclosure being configured to be transparent to a predetermined wavelength of light.

Such an aperture is similar to that of the first aspect, although it does not necessarily require an optical element to split a misaligned laser beam into two or more sub-beams. Instead, it provides for an aperture comprising an enclosure configured to enclose at least one of the body, beam dump, and laser beam detection system. By providing an enclosure, any particles or debris which are generated by a misaligned laser beam are retained by the enclosure and do not contaminate elsewhere. As such, even though part of the aperture may begin to melt before the laser beam is shut off, this will still not result in contamination. The laser beam detection system may be configured to detect laser light directly and/or indirectly. For example, direct detection relies upon the detection of the laser light itself, whereas indirect detection relies upon the heating effect of the laser light.

The enclosure may comprise fused silica or quartz. The enclosure may comprise any material which is optically transparent to light of a wavelength of from around 0.5 to around 1.5 microns.

The enclosure may be configured to diffuse any misaligned laser light. Again, by diffusing misaligned laser light, the intensity of the laser light is reduced when it meets a part of the aperture and thereby slows or reduces the rate at which damage occurs. The diffusion of any misaligned light may be effected by a translucent optical element.

A seal may be provided between the body and the enclosure. The seal prevents any contaminants or debris generated within the enclosure from leaving the enclosure.

The enclosure may be configured to direct laser light away from the seal. The seal may be formed of rubber, which would melt rapidly if it were to be exposed to the misaligned laser beam. As such the enclosure is configured to place the seal in its shadow to prevent damage to the seal. This may be achieved in any suitable way, such as providing an at least partially reflective surface in the path of the laser beam, or providing an angled surface which reflects or refracts the laser light away from the beam.

The laser beam detection system may be configured to detect the laser beam thermally. As such the detector may include a temperature sensor or a thermal switch. Although this may be slower to act than an optical sensor, it may be more resistant to exposure to intense laser light. The laser beam detection system may include an optical sensor. In other words, the laser beam detection system may be configured to detect the laser beam indirectly, such as by its heating effect, or directly, such as via photosensitive means such as photodetectors or photodiodes. The laser beam detection system may include a one or more temperature sensors. Where there are two or more temperature sensors, the temperature sensors may be provided on two or more separate circuits. In this way, should one of the circuits fail to function, the other circuit is able to still detect any temperature fluctuations. Similarly, optical sensors could be provided on two or more separate circuits for the same reason.

Features described in respect of the first aspect of the present invention may be combined with any features described in respect of any other aspect of the present disclosure. Indeed, features described in respect of any aspect may be combined with features of any other aspect described herein unless technically incompatible. All such combinations are expressly considered and disclosed.

Also described is a method of detecting misalignment of a laser beam, the method including splitting the misaligned laser beam into two or more sub-beams, directing one of the sub-beams to a laser beam detector system and directing another one of the sub-beams to a beam dump.

As described in respect of the previous aspects of the present invention, by splitting the misaligned laser beam, it is possible to extend the time before damage to a component occurs and thereby provide more time for safety precautions to take effect.

The method may include enlarging at least one of the sub-beams. By enlarging the sub-beams provided to the beam dump, the intensity of the beam is reduced and thereby damage is avoided or reduced. Similarly, by enlarging the sub-beam provided to the laser beam detection system, the intensity of the laser light is reduced and there is less possibility of the laser light going undetected.

The method may include angling at least one of the sub-beams such that it illuminates the beam dump or laser beam detector at an oblique angle. By angling the sub-beam to such an angle, the sub-beam illuminates a larger area of the beam dump or laser beam detector and thereby reduces the intensity of the laser light.

The method may include generating a signal when misalignment is detected. The signal may be sent to a controller to either turn off the laser beam or to realign the laser beam.

The method may include diverging at least one of the sub-beams, optionally by passing the sub-beam through a translucent optical element.

According to a second aspect of the present invention, there is provided a radiation source including an aperture according to the first aspect of the present invention. The radiation source may be an EUV radiation source or a source suitable for metrology apparatus.

According to a third aspect of the present invention, there is provided a lithographic apparatus including an aperture according to the first aspect of the present invention or a radiation source according to the second aspect of the present invention.

According to a fourth aspect of the present invention, there is provided a metrology apparatus including an aperture according to the firstaspects of the present invention or a radiation source according to the second aspect of the present invention.

Also described is the use of an aperture, radiation source, metrology apparatus, or method according to any aspect of the present invention in a lithographic apparatus or method or in a metrology apparatus.

It will be appreciated that the subject matter of each of the aspects of the present invention may be combined with that of any of the other aspects of the present invention and that any features described in respect of one aspect are equally applicable to any other aspect of the present invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2a depicts an embodiment of the present invention in which the laser beam is in the nominal position and Figure 2b depicts a case where the laser beam is misaligned;
- Figure 2c depicts an aperture similar to the aperture of figures 2a and 2b including an enclosure configured to contain contaminants and debris.
- Figures 3a and 3b depict another configuration of an apparatus according to the present invention;
- Figure 4 depicts another configuration of an apparatus according to the present invention;
- Figure 5a depicts an existing aperture and Figure 5b depicts such an aperture including an enclosure configured to contain contaminants and debris;
- Figure 6 depicts an aperture, which may be an aperture of the present disclosure, including an enclosure;
- Figure 7 depicts an enclosure similar to that shown in Figure 6, albeit with a curved wall configured to enlarge the laser beam;
- Figure 8 depicts an aperture similar to that of Figures 6 and 7 including a laser beam detection system;
- Figure 9 depicts a schematic representation of a metrology apparatus in which EUV and/or SXR radiation is used; and
- Figure 10 depicts a schematic representation of an aperture according to an aspect of the present disclosure including a translucent optical element.
- Figures 11A and 11B depict a schematic representation of an optical element according to an aspect of the present disclosure.

### DETAILED DESCRIPTION

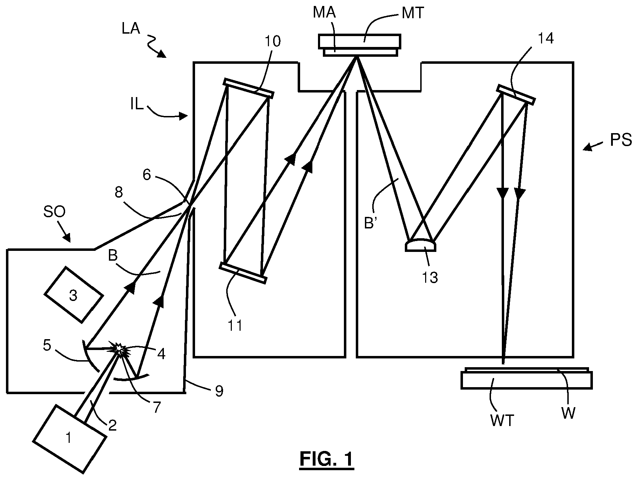

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e., a small amount of gas (e.g., hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g., in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

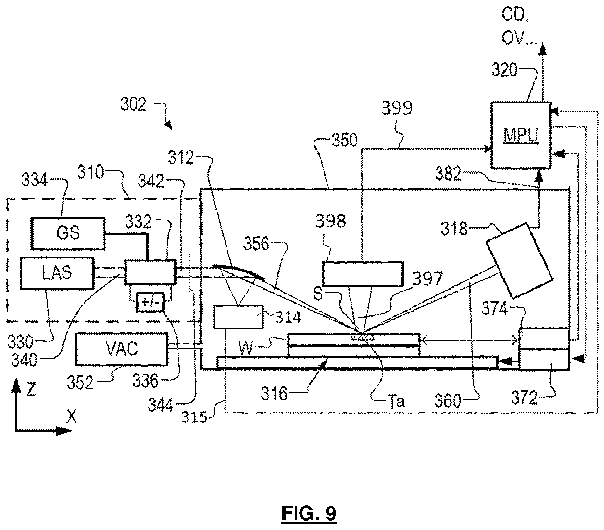

Figure 9 depicts a schematic representation of a metrology apparatus 302 in which the radiation may be used to measure parameters of structures on a substrate. The metrology apparatus 302 presented in Figure 9 may be suitable for the hard X-ray, soft X-rays and/or EUV domain.

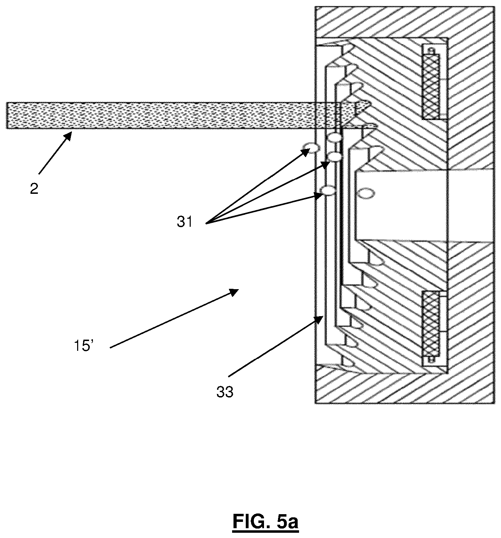

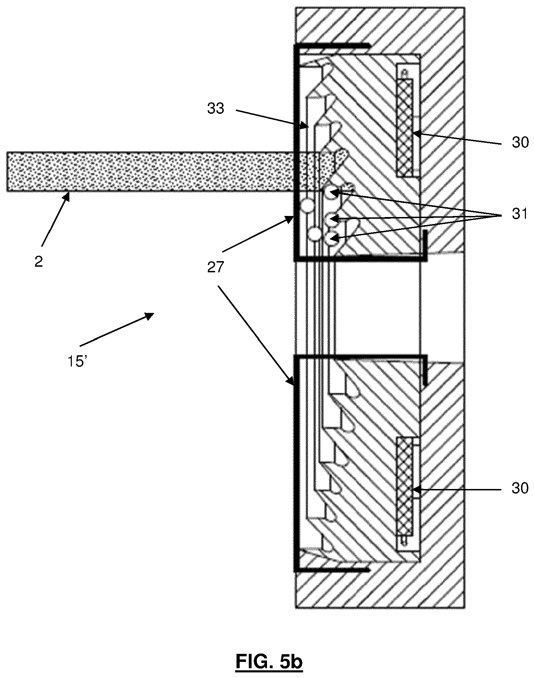

Figure 9 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 9, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 9, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, where in the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example, a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam paths may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example, different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore, to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally, the atmosphere within inspection chamber 350 may be maintained near vacuum by vacuum pump 352, so that SXR and/or EUV radiation may pass with-out undue attenuation through the atmosphere. The illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus, the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 310 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 9, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 9 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned, an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g., due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g., 1 nm to 100 nm), and/or soft X-ray (SXR) radiation (e.g., 0.1 nm to 10 nm), a source may use High Harmonic Generation (HHG) or inverse Compton scattering (ICS) to obtain radiation at the desired wavelength(s).

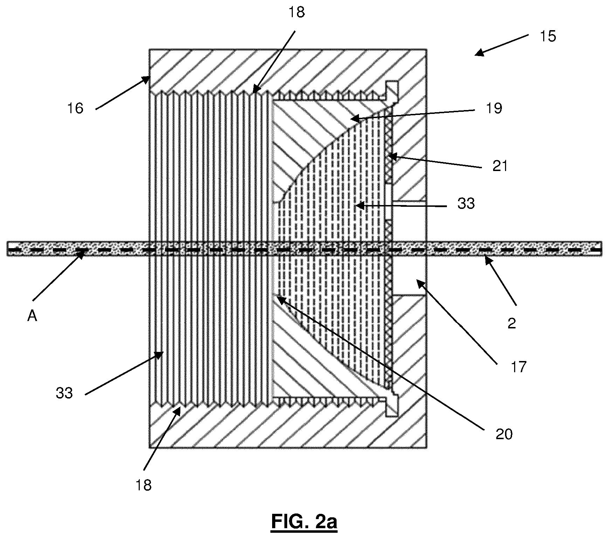

Figure 2a depicts a cut-out of an embodiment of an aperture 15 according to the present invention. The present invention may be used in an EUV radiation source or EUV lithography apparatus shown in figure 1, or in an illumination source of metrology apparatus or metrology tool or metrology apparatus as shown in figure 9. The aperture 15 includes an annular body 16 including a first opening 17 and defining a first axis A, along which the laser beam 2 nominally passes. The annular body 16 includes areas which may act as a beam dump 18. The beam dump 18 may be continuous and may be positioned on the inner wall of the annular body 16. The aperture 15 also includes an optical element 19 which includes a second opening 20. The aperture 15 also includes a laser beam detection system 21. It will be appreciated that the laser beam detection system 21 is provided around the first opening 17 and that the laser beam 2 does not pass through it.

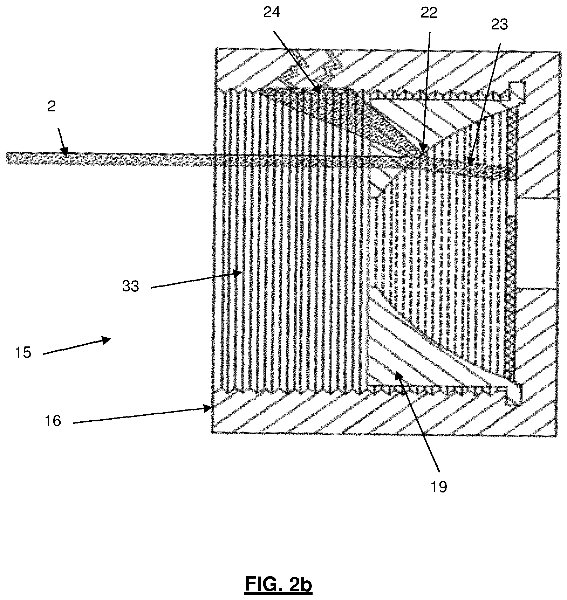

In nominal use where a laser beam 2 is properly aligned, the laser beam passes along axis A and through the first and second openings 17, 20. In the nominal condition, the laser beam 2 passes through the opening in the optical element 19 and the laser beam detection system 21 does not receive any or enough of the laser light from the laser beam 2 to be activated. As shown in Figure 2b, where the laser beam 2 is misaligned, it interacts with the optical element 19. The laser beam 2 interacts with the rear wall 22 of the optical element 19. The rear wall 22 allows a portion of the laser beam 2 to pass through to form a first sub-beam 23. The first sub-beam 23 is of lower power than the laser beam 2 and so it does not damage the laser beam detection system 21. The rear wall 22 also reflects a portion of laser beam 2 to form second sub-beam 24 directed towards beam dump 18. As the rear wall 22 is curved, the second sub-beam 24 is enlarged so that the intensity of the laser light at the beam dump 18 is reduced. In this way, the majority of the energy of the laser beam 2 may be directed to the beam dump 18. Preferably greater than 90%, greater than 95%, greater than 98%, or greater than 99% of the energy of the laser beam 2 is directed to the beam dump 18. As such, only a small amount of the energy of the laser beam 2 is provided to the laser beam detection system 21. As shown in the figures, beam dump 18 may include ridges which are included to reduce or eliminate unwanted reflections. The ridges 33 are shown in continuous lines where they are not overlapped by the optical element 19 and in dashed lines where they are overlapped by the optical element 19. The optical element 19 may be formed from fused silica or quartz. Both of these materials are optically transparent to laser light having a wavelength of around 1 micron.

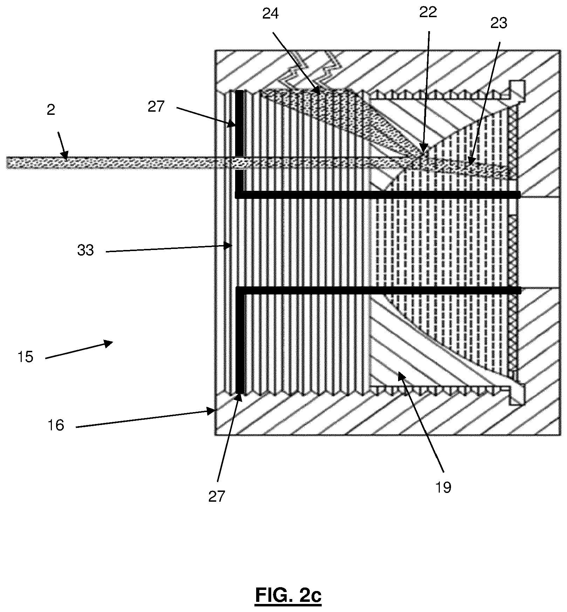

Figure 2c depicts another configuration of the apparatus according to the present invention similar to that of Figures 2a and 2b. In this example, the aperture comprises an enclosure 27. The enclosure 27 is transparent to the wavelength of light of the laser beam 2. In the depicted configuration, the enclosure 27 simply serves to retain any particles or debris generated by damage caused to the aperture 15. The enclosure 27 includes a central aperture through which the laser beam 2 passes in nominal use. It will be appreciated that any aperture described herein may be provided with an enclosure configured to retain particles and debris.

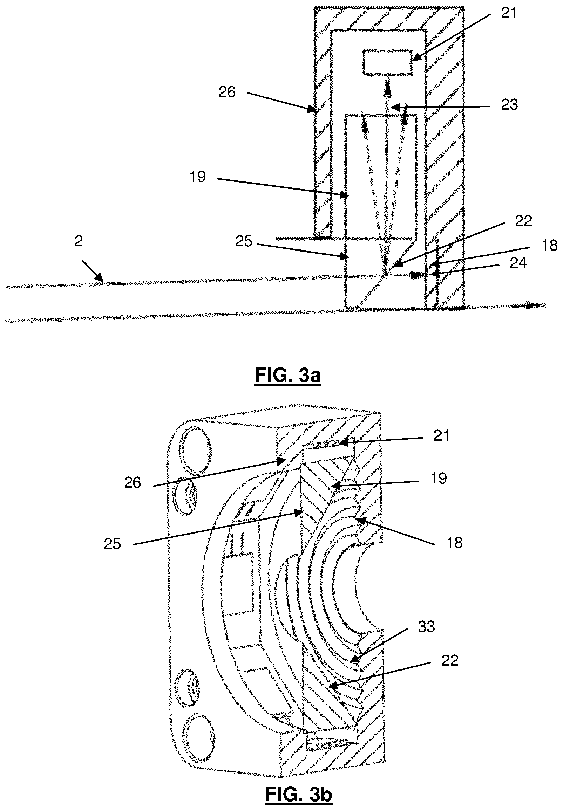

Figure 3a depicts an alternative configuration in which the optical element 19 is configured to allow the majority of the laser beam 2 through to the beam dump 18 and to reflect a minority of the laser beam 2 towards the laser beam detection system 21. The optical element 19 includes a rear wall 22 which is partially reflective such that the laser beam 2 is split into two sub-beams 23, 24. The optical element 19 includes a front wall 25 which has an optional anti-reflective coating. As with the configuration shown in Figures 2a to c, the rear wall 22 may be curved or straight. The aperture 15 may include a screening wall 26 configured to contain the sub-beam directed towards the laser beam detection system 21.

Figure 3b depicts a cross-sectional perspective view of an embodiment of the present invention. The beam dump 18 includes ridges in order to reduce or eliminate unwanted reflections. The laser beam detection system 21 is located around a periphery of the annular body 16.

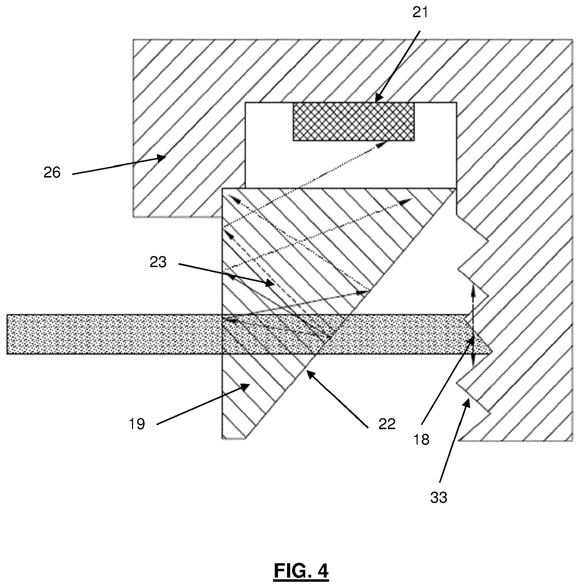

Figure 4 depicts another configuration of the apparatus according to the present invention similar to that of Figure 3. In this configuration, the rear wall 22 is angled such that the first sub-beam 23 propagates through the optical element 19 via internal reflection. The majority of the energy of the laser beam 2 will pass through the optical element 19 and illuminate the beam dump 18. The reflected laser beam 2 will arrive at the laser beam detection system 21.

**In** the embodiments of figures 2a to 4, the laser beam detection system 21 may include one or more photodetectors, which may be photodiodes. The photodiodes are able to detect incident laser light and generate a signal, which can be converted into a signal. Alternatively or additionally, the laser beam detection system may include a plurality of optical fibres configured to directed laser light to one or more photodetectors. The photodetectors may be connected to one or more electronic circuits. The electronic circuit is configured to send a stop signal to the source of the laser beam to stop the source and avoid any further damage.

Figure 5a depicts an existing aperture 15'. For this aperture 15', when the laser beam 2 is misaligned, it causes heating of the aperture 15' which can damage the aperture 15' and generate particles and debris 31. These particles and debris can then contaminate other parts of the lithographic apparatus. Figure 5b depicts an aperture which additionally includes an enclosure 27. The enclosure 27 is transparent to the wavelength of light of the laser beam 2. In the depicted configuration, the enclosure 27 simply serves to retain any particles or debris generated by damage caused to the aperture 15. The enclosure 27 includes a central aperture through which the laser beam 2 passes in nominal use. It will be appreciated that any aperture described herein may be provided with an enclosure configured to retain particles and debris. In figure 5b, the laser detection system comprises two thermal switches 30. The thermal switches may be provided on two or more separate electronic circuits. In this way, should one of the circuits fail to function, the other circuit is able to still detect any temperature fluctuations. The electronic circuit is configured to send a stop signal to the source of the laser beam to stop the source and avoid any further damage.

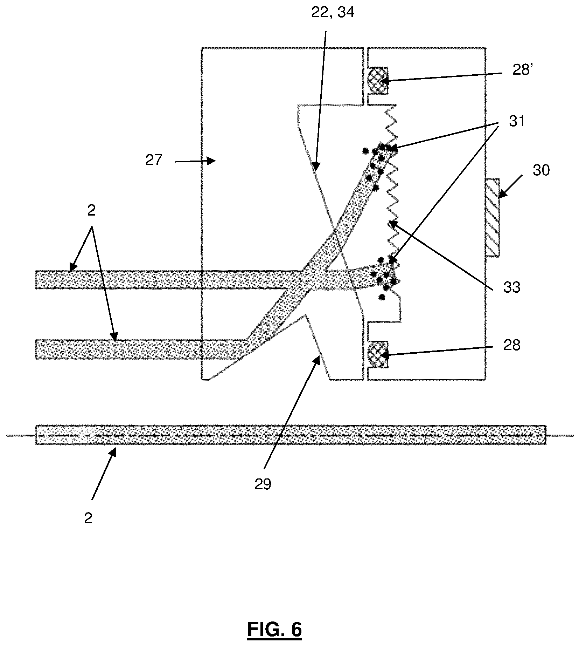

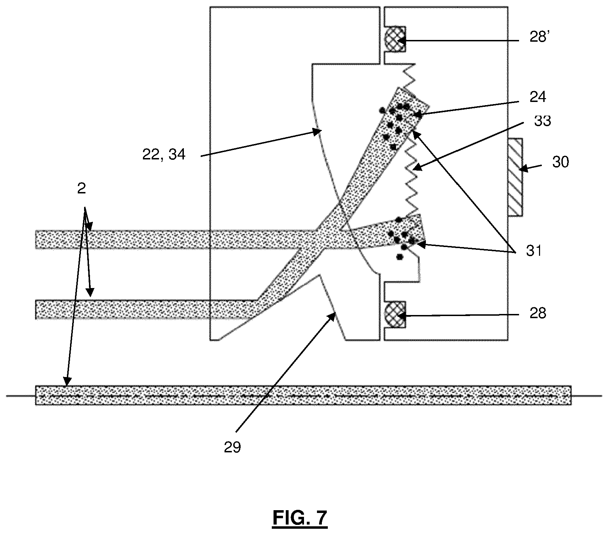

Figures 6 and 7 depict embodiments of the present invention including an enclosure 27 configured to retain any particles or debris generated by damage to the aperture 15. It will be appreciated that the laser beam is shown in its nominal position as well as in misaligned positions for the sake of comparison and example. The rear wall 34 may be linear as shown in Figure 6 or curved as shown in Figure 7. The rear wall 34 may be configured to enlarge the sub-beam 24 such that the intensity of the sub-beam 24 at the beam dump 18 is reduced. The rear wall 34 may be configured to angle the sub-beam 24 such that it illuminates the beam dump 18 at an oblique angle, thereby reducing the intensity of sub-beam 24 at the beam dump 18. The apparatus may include seal 28. The seal 28 may be an o-ring and may be formed of rubber. There may be more than one seal 28, 28'. The enclosure 27 may include a wall 29 that is configured to protect the seal 28 from the laser beam 2. The wall 29 may be at least partially reflective or angled to have a low angle of incidence with the laser beam 2 to reflect the majority of the laser beam 2 away from the seal 28. The annular body 16 may be provided with a thermal switch 30, which is responsive to changes in temperature and is configured to shut off the laser beam 2 when it detects that the temperature is above a predetermined level.

In a particular embodiment, the aperture comprises a plurality of thermal switches 30. The thermal switches 30 may be connected to different electronic circuits. A first set of thermal switches 30 may be connected to a first electronic circuit and a second set of thermal switches 30 may be connected to a second electronic circuit. The thermal switches 30 may be arranged in the periphery of the first aperture in a ring-fashion scheme. Advantageously, this allows to comply with SIL-3 regulations because it provides a failsafe for the situations when one of the circuits is not working. The likelihood of have a double fail with two or more electronics circuits is very low. Advantageously, the aperture is configured to switch the laser off the laser soon enough, even if one circuit is malfunctioning. The number of thermal switches 30 in each set of thermal switches may be between 2 and 10. The electronic circuit is configured to send a stop signal to the source of the laser beam to stop the source and avoid any further damage.

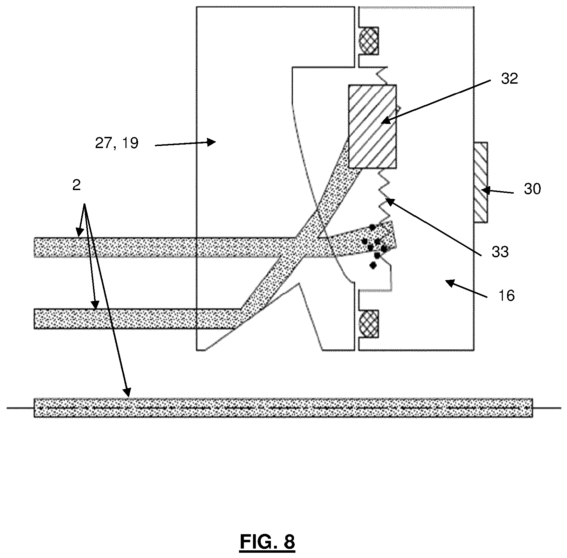

Figure 8 is similar to Figures 6 and 7, albeit with an optical sensor 32 disposed between the enclosure 27 and the body 16. As described above, the enclosure 27 may be the optical element 19 which interacts with the laser light 2 such that the optical sensor is able to detect the misalignment through detection of the laser light 2. The enclosure 27 is configured such that the intensity of the laser light 2 provided to the optical sensor 32 is reduced to avoid damage to the optical sensor 32. The thermal switch 30 may also optionally be provided or could be eliminated in place of the optical sensor 32. It will be appreciated that the optical element 19 and the enclosure 27 may be provided as a single piece. In such cases, the rear wall 22 of the optical element is the rear wall of the enclosure 22, 34. In such a configuration, the optical element/enclosure is configured to split a misaligned laser beam into at least two sub-beams as per the first aspect of the present invention and to also retain any contaminants or debris as per the second aspect of the present invention.

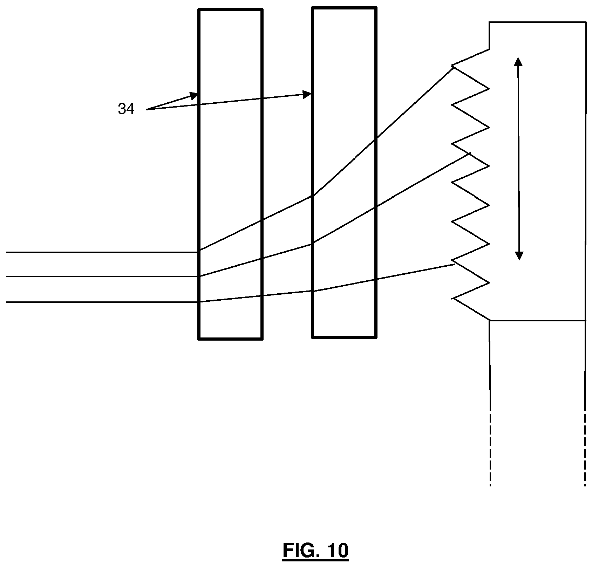

Figure 10 depicts an configuration in which two translucent optical elements 34 are provided. It will be appreciated that in some embodiments, only a single translucent element 34 may be provided. It will also be appreciated that the optical element depicted in the previous figures may in some embodiments be at least partially translucent. As with the other embodiments, the translucent optical elements 34 may be substantially annular or doughnut shaped with a hole in the centre through which a nominal laser beam may pass unimpeded. The misaligned laser beam (shown as three initially parallel lines) passes through the first translucent optical element 34 where it is caused to diverge. The misaligned laser beam then passes through the second translucent optical element 34 which further divergence of the misaligned laser beam occurs. As a result, when the misaligned laser beam hits the aperture, it is spread out over a larger area than would have otherwise been the case. A translucent optical element may be advantageous on the basis that it may be in the form of a flat disc with a central hole that has a rough surface finish, meaning that it is simpler to produce than a curved optical element intended to perform the same function of diverging a laser beam since no accurate surface polishing is required.

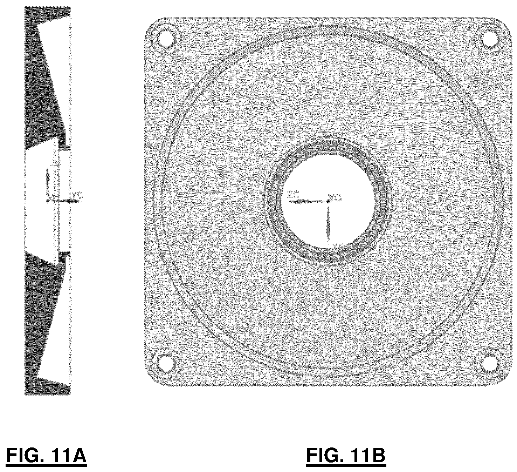

Figures 11A and 11B depict one embodiment of an optical element according to the present disclosure. Figure 11A shown a cross section of the optical element including a central hole through which an aligned laser beam passes in use. Figure 11B is a front view of the optical element showing the central opening.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g., carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. An aperture (15) for detecting misalignment of a laser beam (2) configured to generate plasma when it hits a target, the aperture comprising:
- a body (16) including a first opening (17) and defining a first axis (A);
- a beam dump (18);
- an optical element (19) including a second opening (20) wherein the first opening (17) and the second opening (20) are coaxial with the first axis (A), the optical element (19) being configured to split a misaligned laser beam (2), which interacts with the optical element (19), into at least two sub-beams (23, 24) and to allow a nominal laser beam (2) to pass along the first axis (A) through the first and second openings (17, 20);
- a laser beam detection system (21) configured to detect laser light, wherein the optical element (19) is configured to direct a first sub-beam (23) to the beam dump (18), and to direct a second sub-beam (24) to the laser beam detection system (21).

2. The aperture according to claim 1, wherein the optical element (19) includes a partially reflective surface configured to reflect a portion of incident laser beam (2) and to transmit another portion of the incident laser beam (2).

3. The aperture according to claim 1 or 2 wherein the optical element (19) is configured to enlarge the first sub-beam (23), optionally wherein the optical element (19) includes a curved surface configured to enlarge the first sub-beam (23).

4. The aperture according to any preceding claim, wherein the laser beam detection system (21) is configured to detect a misalignment of the laser beam (2) and send a signal when misalignment is detected.

5. The aperture according to any preceding claim, wherein the laser beam detection system (21) includes one or more photodetectors, optionally photodiodes, and/or a plurality of optical fibres configured to direct laser light to one or more photodetectors.

6. The aperture according to any preceding claim, wherein the optical element (19) is configured to at least partially diffuse the second sub-beam (24).

7. The aperture according to any preceding claim, wherein the aperture (15) includes a diffuser to at least partially diffuse the second sub-beam (24).

8. The aperture according to any preceding claim, wherein the optical element (19) is configured to be transmissive to laser light of around 1 micron in wavelength.

9. The aperture according to any preceding claim, wherein the aperture (15) includes an enclosure (27) which is optically transparent to light of a predetermined wavelength.

10. The aperture according to claim 9, wherein the enclosure (27) encloses at least one of the optical element (19), beam dump (18), and laser beam detection system (21), optionally the enclosure (27) may form at least a part of the optical element (19).

11. The aperture according to any preceding claim, wherein the optical element (19) is configured to enclose the beam dump (18) and the laser beam detection system (21).

12. The aperture according to any preceding claims, wherein a seal (28) is provided between the body (16) and the optical element (19).

13. The aperture according to claim 12, wherein the optical element (19) is configured to direct laser light away from the seal (28).

14. The aperture according to any preceding claim, wherein the aperture (15) further includes a translucent optical element (34) configured to diverge the misaligned laser beam (2).

15. The aperture according to Claim 14, wherein the translucent optical element (34) is the optical element (19) including a second opening (20) wherein the first opening (17) and the second opening (20) are coaxial with the first axis (A).

16. A radiation source (SO, 330) or a metrology tool (MT) including an aperture (15) according to any of claims 1 to 15.

17. A lithographic apparatus (LA) including an aperture (15) according to any of claims 1 to 15 or radiation source (SO, 330) according to claim 16.

## Patentansprüche

1. Eine Blende (15) zum Detektieren einer Fehlausrichtung eines Laserstrahls (2), der konfiguriert ist, um Plasma zu erzeugen, wenn er ein Target trifft, wobei die Blende Folgendes beinhaltet:
- einen Körper (16), der eine erste Öffnung (17) umfasst und eine erste Achse (A) definiert;
- ein Strahlfalle (18);
- ein optisches Element (19), das eine zweite Öffnung (20) umfasst, wobei die erste Öffnung (17) und die zweite Öffnung (20) mit der ersten Achse (A) koaxial sind, wobei das optische Element (19) konfiguriert ist, um einen fehlausgerichteten Laserstrahl (2), der mit dem optischen Element (19) wechselwirkt, in mindestens zwei Teilstrahlen (23, 24) zu teilen und zu ermöglichen, dass ein nominaler Laserstrahl (2) entlang der erste Achse (A) durch die erste und die zweite Öffnung (17, 20) durchgeht;
- ein Laserstrahldetektionssystem (21), das konfiguriert ist, um Laserlicht zu detektieren, wobei das optische Element (19) konfiguriert ist, um einen ersten Teilstrahl (23) zu der Strahlfalle (18) zu lenken und einen zweiten Teilstrahl (24) zu dem Laserstrahldetektionssystem (21) zu lenken.

2. Blende gemäß Anspruch 1, wobei das optische Element (19) eine teilweise reflektierende Oberfläche umfasst, die konfiguriert ist, um einen Anteil eines einfallenden Laserstrahls (2) zu reflektieren und einen anderen Anteil des einfallenden Laserstrahls (2) durchzulassen.

3. Blende gemäß Anspruch 1 oder 2, wobei das optische Element (19) konfiguriert ist, um den ersten Teilstrahl (23) zu verbreitern, wobei das optische Element (19) optional eine gekrümmte Oberfläche umfasst, die konfiguriert ist, um den ersten Teilstrahl (23) zu verbreitern.

4. Blende gemäß einem der vorhergehenden Ansprüche, wobei das Laserstrahldetektionssystem (21) konfiguriert ist, um eine Fehlausrichtung des Laserstrahls (2) zu detektieren und ein Signal zu senden, wenn die Fehlausrichtung detektiert wird.

5. Blende gemäß einem der vorhergehenden Ansprüche, wobei das Laserstrahldetektionssystem (21) einen oder mehrere Photodetektoren, optional Photodioden, und/oder eine Vielzahl von Lichtleitfasern, die konfiguriert sind, um Laserlicht auf einen oder mehrere Photodetektoren zu lenken, umfasst.

6. Blende gemäß einem der vorhergehenden Ansprüche, wobei das optische Element (19) konfiguriert ist, um den zweiten Teilstrahl (24) mindestens teilweise zu zerstreuen.

7. Blende gemäß einem der vorhergehenden Ansprüche, wobei die Blende (15) einen Diffusor umfasst, um den zweiten Teilstrahl (24) mindestens teilweise zu zerstreuen.

8. Blende gemäß einem der vorhergehenden Ansprüche, wobei das optische Element (19) konfiguriert ist, um für Laserlicht mit einer Wellenlänge von etwa 1 Mikrometer durchlässig zu sein.

9. Blende gemäß einem der vorhergehenden Ansprüche, wobei die Blende (15) eine Umhausung (27) umfasst, die für Licht einer vorgegebenen Wellenlänge optisch transparent ist.

10. Blende gemäß Anspruch 9, wobei die Umhausung (27) mindestens eines von dem optischen Element (19), der Strahlfalle (18) und dem Laserstrahldetektionssystem (21) umschließt, wobei die Umhausung (27) optional mindestens einen Teil des optischen Elements (19) bilden kann.

11. Blende gemäß einem der vorhergehenden Ansprüche, wobei das optische Element (19) konfiguriert ist, um die Strahlfalle (18) und das Laserstrahldetektionssystem (21) zu umschließen.

12. Blende gemäß einem der vorhergehenden Ansprüche, wobei zwischen dem Körper (16) und dem optischen Element (19) eine Dichtung (28) bereitgestellt ist.

13. Blende gemäß Anspruch 12, wobei das optische Element (19) konfiguriert ist, um Laserlicht von der Dichtung (28) wegzulenken.

14. Blende gemäß einem der vorhergehenden Ansprüche, wobei die Blende (15) ferner ein durchscheinendes optisches Element (34) umfasst, das konfiguriert ist, um den fehlausgerichteten Laserstrahl (2) divergieren zu lassen.

15. Blende gemäß Anspruch 14, wobei das durchscheinende optische Element (34) das optische Element (19) ist, das eine zweite Öffnung (20) umfasst, wobei die erste Öffnung (17) und die zweite Öffnung (20) mit der ersten Achse (A) koaxial sind.

16. Eine Strahlungsquelle (SO, 330) oder ein Metrologiewerkzeug (MT), die/das eine Blende (15) gemäß einem der Ansprüche 1 bis 15 umfasst.

17. Ein lithographisches Gerät (LA), das eine Blende (15) gemäß einem der Ansprüche 1 bis 15 oder eine Strahlungsquelle (SO, 330) gemäß Anspruch 16 umfasst.

## Revendications

1. Une ouverture (15) pour détecter le désalignement d'un faisceau laser (2) configuré afin de générer du plasma lorsqu'il frappe une cible, l'ouverture comprenant :
- un corps (16) incluant un premier orifice (17) et définissant un premier axe (A) ;
- une décharge de faisceau (18) ;
- un élément optique (19) incluant un deuxième orifice (20) où le premier orifice (17) et le deuxième orifice (20) sont coaxiaux avec le premier axe (A), l'élément optique (19) étant configuré afin de diviser un faisceau laser (2) désaligné, lequel interagit avec l'élément optique (19), en au moins deux sous-faisceaux (23, 24) et afin de permettre à un faisceau laser (2) nominal de longer le premier axe (A) en passant à travers les premier et deuxième orifices (17, 20) ;
- un système de détection de faisceau laser (21) configuré afin de détecter de la lumière laser, où l'élément optique (19) est configuré afin de diriger un premier sous-faisceau (23) jusqu'à la décharge de faisceau (18), et afin de diriger un deuxième sous-faisceau (24) jusqu'au système de détection de faisceau laser (21).

2. L'ouverture selon la revendication 1, où l'élément optique (19) inclut une surface partiellement réfléchissante configurée afin de réfléchir une portion de faisceau laser (2) incident et afin de transmettre une autre portion du faisceau laser (2) incident.

3. L'ouverture selon la revendication 1 ou la revendication 2 où l'élément optique (19) est configuré afin d'agrandir le premier sous-faisceau (23), facultativement où l'élément optique (19) inclut une surface courbe configurée afin d'agrandir le premier sous-faisceau (23).

4. L'ouverture selon n'importe quelle revendication précédente, où le système de détection de faisceau laser (21) est configuré afin de détecter un désalignement du faisceau laser (2) et d'envoyer un signal lorsqu'un désalignement est détecté.

5. L'ouverture selon n'importe quelle revendication précédente, où le système de détection de faisceau laser (21) inclut un ou plusieurs photodétecteurs, facultativement des photodiodes, et/ou une pluralité de fibres optiques configurées afin de diriger de la lumière laser jusqu'à un ou plusieurs photodétecteurs.

6. L'ouverture selon n'importe quelle revendication précédente, où l'élément optique (19) est configuré afin de diffuser au moins partiellement le deuxième sous-faisceau (24).

7. L'ouverture selon n'importe quelle revendication précédente, où l'ouverture (15) inclut un diffuseur afin de diffuser au moins partiellement le deuxième sous-faisceau (24).

8. L'ouverture selon n'importe quelle revendication précédente, où l'élément optique (19) est configuré afin d'être transmissif pour de la lumière laser d'autour de 1 micron de longueur d'onde.

9. L'ouverture selon n'importe quelle revendication précédente, où l'ouverture (15) inclut un boîtier (27) qui est optiquement transparent pour de la lumière d'une longueur d'onde prédéterminée.

10. L'ouverture selon la revendication 9, où le boîtier (27) renferme au moins un élément parmi l'élément optique (19), la décharge de faisceau (18), et le système de détection de faisceau laser (21), facultativement le boîtier (27) pouvant former au moins une partie de l'élément optique (19).

11. L'ouverture selon n'importe quelle revendication précédente, où l'élément optique (19) est configuré afin de renfermer la décharge de faisceau (18) et le système de détection de faisceau laser (21).

12. L'ouverture selon n'importe quelles revendications précédentes, où un joint d'étanchéité (28) est fourni entre le corps (16) et l'élément optique (19).

13. L'ouverture selon la revendication 12, où l'élément optique (19) est configuré afin de diriger de la lumière laser à l'écart du joint d'étanchéité (28).

14. L'ouverture selon n'importe quelle revendication précédente, où l'ouverture (15) inclut en sus un élément optique translucide (34) configuré afin de faire diverger le faisceau laser (2) désaligné.

15. L'ouverture selon la revendication 14, où l'élément optique translucide (34) est l'élément optique (19) incluant un deuxième orifice (20) où le premier orifice (17) et le deuxième orifice (20) sont coaxiaux avec le premier axe (A).

16. Une source de rayonnement (SO, 330) ou un outil de métrologie (MT) incluant une ouverture (15) selon n'importe lesquelles des revendications 1 à 15.

17. Un appareil lithographique (LA) incluant une ouverture (15) selon n'importe lesquelles des revendications 1 à 15 ou une source de rayonnement (SO, 330) selon la revendication 16.
